(19)

**Europäisches Patentamt**

**European Patent Office**

**Office européen des brevets**

(11) **EP 4 591 983 A1**

(12) **EUROPEAN PATENT APPLICATION**

(43) Date of publication:
30.07.2025 Bulletin 2025/31

(51) International Patent Classification (IPC):
**B01L 7/00** (2006.01)     **G01N 27/74** (2006.01)
**G01R 33/12** (2006.01)

(21) Application number: 24153492.4

(22) Date of filing: 23.01.2024

(52) Cooperative Patent Classification (CPC):
**B01L 7/00; G01N 27/745; G01R 33/1269;**
B01L 2200/0647; B01L 2300/0681;
B01L 2300/0832; B01L 2300/1816

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **Fraunhofer-Gesellschaft zur Förderung
der angewandten Forschung e.V.
80686 München (DE)**
• **Forschungszentrum Jülich GmbH
52425 Jülich (DE)**

(72) Inventors:
• **Jessing, Max
52425 Jülich (DE)**
• **Abuawad, Abdalhalim
52425 Jülich (DE)**
• **Krause, Hans-Joachim
52425 Jülich (DE)**
• **Schöper, Florian
80686 München (DE)**

(74) Representative: **Kuttenkeuler, David
SKM-IP PartGmbB
Oberanger 45
80331 München (DE)**

(54) **APPARATUS AND METHOD FOR COMBINED AMPLIFICATION AND DETECTION OF A SOLUTION**

(57)     The present invention provides an apparatus for combined amplification and detection of a solution including one or more substances, such as DNA- or RNA-sequences, comprising: at least one excitation assembly configured to provide, on the basis of one or more electrical signals, at least one excitation magnetic field for the solution; at least one detection assembly configured to receive and/or detect at least a response magnetic field from at least one or more, in particular magnetic, nanoparticles (MNP) added to the solution; and at least one, in particular thermal, controller configured to control, in particular modify, the one or more electrical signals to adjust and/or regulate a temperature for, in particular isothermal, amplification of the one or more substances. Also, a method for combined amplification and detection of a solution including one or more substances, such as DNA- or RNA-sequences, using a single respective apparatus, is provided.

Fig. 1A

**Description**

FIELD OF THE INVENTION

The invention relates to an apparatus and a method for combined amplification and detection of a solution including one or more substances, such as DNA- or RNA-sequences.

DESCRIPTION

Isothermal amplification methods, which may serve as an alternative to the Polymerase Chain Reaction (PCR), such as RPA (Recombinase Polymerase Amplification) or LAMP (Loop-Mediated Isothermal Amplification), are increasingly utilized due to their ease of execution, speed, and their fundamental applicability in field tests, particularly in the specific detection of nucleic acid templates for various infectious diseases. Controlling the optimal temperature range for isothermal amplification is crucial. Currently, this is typically achieved by using external temperature control equipment such as commercial thermoblock incubators or external temperature-regulated water baths.

Detection of the amplification products mainly occurs after the amplification process through the use of additional approaches and measurement systems. These methods include optical readout techniques for the qualitative analysis of dye-labelled amplification products or quantitative PCR (qPCR) analysis. In PCR analysis and detection, for example, in nucleic acid assays, nucleic acid samples usually need to be submitted and replicated and analysed by appropriately equipped laboratories. This process is, however, time-consuming and costly. Particularly, quantitative analyses that examine the replication of nucleic acids in real-time can only be performed in specialized analysis laboratories with the required technical equipment, often using qPCR.

Although approaches for quantitative analysis using isothermal amplification have been described, they are complex. Especially when it comes to measuring the yield of nucleic acid replication or further analysing the generated amplification product in the form of nucleic acid assays for pathogen determination, suitable isothermal approaches are lacking. This necessitates additional (usually expensive) measurement systems to quantitatively detect the attachment or incorporation of colour markers and demonstrate them, for instance, to identify the presence of colour markers like fluorescence dyes, which can be problematic, particularly in the context of contaminated environmental samples or turbid/dyed analytes.

It is an object of the invention to overcome the drawbacks of the prior art and to provide an improved method and/or apparatus which, in particular enables improved amplification and detection of a solution.

BRIEF DESCRIPTION OF THE INVENTION

Generally, and by way of brief description, the main aspects of the present invention can be described as follows:

In a **first aspect,** the invention pertains to an apparatus for combined amplification and detection of a solution including one or more substances, such as DNA- or RNA-sequences, comprising: at least one excitation assembly configured to provide, on the basis of one or more electrical signals, at least one excitation magnetic field for the solution; at least one detection assembly configured to receive and/or detect a response magnetic field from at least one or more, in particular magnetic, nanoparticles (MNP) added to the solution; and at least one, in particular thermal, controller configured to control, in particular modify, the one or more electrical signals to adjust and/or regulate a temperature for, in particular isothermal, amplification of the one or more substances.

In a **second aspect,** the invention pertains to a method for combined amplification and detection of a solution including one or more substances, such as DNA- or RNA-sequences, using a single apparatus, in particular an apparatus according to one or more of the aspects and/or embodiments disclosed herein, comprising the steps of: providing one or more electrical signals to at least one excitation assembly for providing at least one excitation magnetic field for the solution; detecting, using a detection assembly, a response magnetic field from at least one or more, in particular magnetic, nanoparticles (MNP) added to the solution; and regulating a temperature for amplification of the one or more substances by controlling, in particular modifying, the one or more electrical signals provided to the at least one excitation assembly.

In a **third aspect,** the invention pertains to a computer-implemented method for determining and/or developing one or more models, in particular one or more thermal models, indicative of a temperature behaviour of an apparatus, in particular according to one or more of the aspects and/or embodiments disclosed herein, for amplification, in particular isothermal amplification, and detection, in particular concentration detection, of a solution, including one or more substances, such as DNA- or RNA-sequences, comprising:

determining, on the basis of a first input value, in particular a power value of an excitation assembly, at least one heating approximation value on a first path of the model, and

determining, on the basis of a second input value, in particular a temperature value, preferably an ambient temperature value, at least one cooling approximation value on a second path of the model.

In a **fourth aspect,** the invention pertains to an apparatus, in particular data processing apparatus, comprising means, in particular at least one processor, for carrying out the method according to one or more of the aspects and/or embodiments disclosed herein.

In a **fifth aspect,** the invention pertains to a computer program product comprising instructions, which, when the program is executed by a computer, cause the computer to carry out the method according to one or more of the aspects and/or embodiments disclosed herein.

In a **sixth aspect,** the invention pertains to a computer-readable storage medium comprising instructions, which, when executed by a computer, cause the computer to carry out the method according to one or more of the aspects and/or embodiments disclosed herein.

DETAILED DESCRIPTION OF THE INVENTION

The subject-matter provided by the present invention is defined in the independent claims, while preferred embodiments of the present invention are defined in the dependent claims.

In the following, the elements of the invention will be described. These elements are listed with specific embodiments, however, it should be understood that they may be combined in any manner and in any number to create additional embodiments. The variously described examples and preferred embodiments should not be construed to limit the present invention to only the explicitly described embodiments. This description should be understood to support and encompass embodiments which combine two or more of the explicitly described embodiments or which combine the one or more of the explicitly described embodiments with any number of the disclosed and/or preferred elements. Furthermore, any permutations and combinations of all described elements in this application should be considered disclosed by the description of the present application unless the context indicates otherwise.

The terms "of the [present] invention", "in accordance with the invention", "according to the invention" and the like, as used herein are intended to refer to all aspects and embodiments of the invention described and/or claimed herein.

As used herein, the term "comprising" is to be construed as encompassing both "including" and "consisting of", both meanings being specifically intended, and hence individually disclosed embodiments in accordance with the present invention. Where used herein, "and/or" is to be taken as specific disclosure of each of the two specified features or components with or without the other. For example, "A and/or B" is to be taken as specific disclosure of each of (i) A, (ii) B and (iii) A and B, just as if each is set out individually herein. In the context of the present invention, the terms "about" and "approximately" denote an interval of accuracy that the person skilled in the art will understand to still ensure the technical effect of the feature in question. The term typically indicates deviation from the indicated numerical value by $\pm 20\%$, $\pm 15\%$, $\pm 10\%$, and for example $\pm 5\%$. As will be appreciated by the person of ordinary skill, the specific such deviation for a numerical value for a given technical effect will depend on the nature of the technical effect. For example, a natural or biological technical effect may generally have a larger such deviation than one for a man-made or engineering technical effect. As will be appreciated by the person of ordinary skill, the specific such deviation for a numerical value for a given technical effect will depend on the nature of the technical effect. For example, a natural or biological technical effect may generally have a larger such deviation than one for a man-made or engineering technical effect. Where an indefinite or definite article is used when referring to a singular noun, e.g. "a", "an" or "the", this includes a plural of that noun unless something else is specifically stated.

Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

Embodiments described herein relate to an apparatus for combined amplification and detection of a solution including one or more substances, such as nucleic acids, e.g. Deoxyribonucleic Acid (DNA)- and/or Ribonucleic Acid (RNA)-sequences.

"Combined amplification and detection" may be understood in that the apparatus is arranged and/or configured to perform both i) amplification, in particular isothermal amplification, e.g. of a sample, solution and/or target material, such as DNA- and/or RNA sequences, and ii) detection, in particular concentration detection, preferably of the amplified sample, solution and/or target material. In other words, amplification i) and detection ii) can be carried out using/within a single apparatus, e.g. simultaneously (e.g. in parallel and/or at the same time) and/or sequentially (e.g. one after another and/or successively). Preferably combined amplification and detection may be carried out by means of and/or within a single, e.g. the same, device or apparatus, preferably portably and/or mobile. This offers the possibility to dispense with external thermoregulators/water baths which are typically used for nucleic acid amplification and to conduct isothermal amplifications and in particular also detection thereof portably, e.g. using a single handheld, or mobile device or apparatus.

Amplification, in particular isothermal amplification, preferably RPA (Recombinase Polymerase Amplification) or LAMP (Loop-Mediated Isothermal Amplification), may be understood as technique used to amplify, duplicate and/or reproduce substances such as DNA- or RNA sequences, e.g. at substantially constant temperatures. Thus, temperature regulation plays an important role. During isothermal amplification, specific primers or probes may target the DNA or RNA sequences of interest. Enzymes or processes may be used to continuously replicate the DNA or RNA sequences, e.g. at a constant temperature. The amplification process typically results in a significant increase in the amount of the targeted nucleic acid, making it easier to detect and analyse.

Detection, in particular concentration detection, may comprise Frequency Mixing Magnet Detection (FMMD), which includes mixing different signals, e.g. having different frequencies, such as magnetic fields, to create a resultant signal, which is utilized for detection purposes, such as detection of the presence of magnetic materials or substances. For the detection, the nucleic acids may be labelled with preferably magnetic nanoparticles (MNP), e.g. before, after or during the execution of an assay on a binding matrix (e.g. sequential detection) or by binding nucleic acids to complement-modified MNPs in a liquid phase before, during or after amplification. Magnetic nanoparticles or MNP's may be made from magnetic material, such as iron, nickel and/or cobalt. While hydrodynamic particle sizes may vary from 50-1000 nm, an exemplary size of the MNP's may not be larger than 30 nm

According to the invention, the apparatus may comprise at least one excitation assembly configured to provide, on the basis of one or more electrical signals, at least one excitation magnetic field for the solution.

An "excitation assembly" may be understood as an arrangement, a device, an apparatus or system that is arranged and/or configured to provide at least one magnetic field, preferably at least two magnetic fields, which may be different from each other. The at least one (or two) magnetic field(s) may be generated on the basis of one or more electrical signals applied to the excitation assembly. For example, the excitation assembly may be comprised of and/or may include one or more components, such as one or more coils or one or more excitation coils, such as a first and a second coil or excitation coil, preferably a driver coil and a probing coil. A "driver" coil may be understood as a coil, e.g. at least partly or primarily, responsible for the amplification process described herein, e.g. to drive the same and/or, e.g. at least partly or primarily, responsible for the heat generation. A "probing" coil may be understood as a coil, e.g. at least partly or primarily, responsible for probing the signal to be detected, e.g. to introduce at least one additional magnetic field or an excitation component, in particular in relation to the excitation component introduced by the driver coil, wherein this at least one additional magnetic field or the excitation component may also be responsible for the, in particular frequency, mixtures mentioned herein, or within the detected signal. The probing coil may refer to a coil responsible for providing a first or primary magnetic field, e.g. a high frequency (HF) magnetic field or HF excitation component, in particular on the basis of a first electrical signal, e.g. a first current. The probing coil may thus, be also referred to as HF-coil. The driver coil may refer to a coil responsible for providing a second or secondary magnetic field, e.g. a low frequency (LF) magnetic field or LF excitation component, in particular on the basis of a second electrical signal, e.g. a second current, which may be different from the first current, e.g. different by frequency, amplitude and/or phase. The driver coil may thus, be also referred to as LF-coil. In this example, at least the relation HF>LF may hold. Suitable HF-frequencies, e.g. when using FMMD, may be selected in the range of approximately 30-40 kHz, , wherein multiples of 10 kHz may be possible, and/or suitable LF-frequencies may be selected in the range of approximately 4-100 Hz wherein multiples of 10 Hz may be possible.

The at least one excitation assembly and/or in particular the driver coil and/or the probing coil may provide the magnetic excitation fields on the basis of one or more electrical signals.

An "electrical signal" may be a signal carrying an electrical quantity, parameter, information and/or value including for example voltage, current and/or resistance. In addition or alternatively, an electrical signal may be an electromagnetic wave that carries information. Examples for electrical signals may include alternating current (AC) signals or direct current (DC) signals. For an AC signal, for example, voltage or current may alternate, e.g. continuously, in direction and/or magnitude, e.g., the flow of electricity periodically reverses direction, cycling between positive and negative polarities. This back-and-forth movement may create a sinusoidal waveform. The voltage and current levels may change with time, typically following a periodic oscillation which can be measured in Hertz (Hz; i.e. frequency), and which determines how many cycles occur in, e.g., a second (s).

The electrical signals may comprise, as an example, two different electrical currents, e.g. two different alternating currents (AC) which have different frequencies $f_1$ and $f_2$ and/or, for example different amplitudes $A_1/A_2$, which may be applied to the excitation assembly and/or the probing coil and the driver coil respectively. For example, a first AC current, $AC_1$, having a frequency $f_1$ (or amplitude $A_1$) may flow through/be applied to the probing coil and a second AC current, $AC_2$, having a frequency $f_2$ (or amplitude $A_2$) may flow through/be applied to the driver coil. The first frequency $f_1$ may be different from the second frequency $f_2$, e.g. following the relation $f_1 > f_2$ (note that in some cases $f_2 > f_1$ may be conceivable). As mentioned above, the first AC current, $AC_1$, may be used to generate the HF magnetic field or HF excitation component and the second AC current, $AC_2$, may be used to generate the LF magnetic field or LF excitation component, or vice versa. The one or more electrical signals may also be referred to as electrical excitation signals or excitation signals, since these are responsible for the provision of the one or more magnetic fields. The magnetic fields mentioned herein may therefore be also referred to as excitation magnetic fields or simply magnetic fields. The first frequency $f_1$ and/or the second frequency $f_2$ may be selected according to the ranges of the HF- and/or LF-frequencies recited herein.

According to the invention, the apparatus may comprise at least one detection assembly configured to receive and/or detect at least a response magnetic field from at least one or more, in particular magnetic, nanoparticles (MNP) added to the solution.

The "detection assembly" may be understood as an arrangement, a device, an apparatus or system, for example one or more coils, preferably one or more detection- and/or reference coils, arranged and/or configured to detect at least one magnetic field. For example, according to Faraday's law of induction, the detection assembly may experience or inhibit an induced voltage resulting from the excitation assembly, in particular by the applied magnetic fields, e.g. the high frequency (HF) magnetic field or HF excitation component and the low frequency (LF) magnetic field or LF excitation component. In addition thereto, the detection assembly may experience additional induced voltages, so called mixtures, (e.g. $HF\pm 2*NF$, $HF\pm 4*NF$, ..., etc.) resulting from additional magnetic fields or excitation components, e.g. from the magnetic nano particles (MNP). The amplitude of the additional excitation components of the induced voltage may be used to infer information about the concentration of the magnetic particles or MNPs in the sample or the solution.

The MNP's may be used to identify and/or detect one or more amplification products. The wording "added to the solution" may include instances in time in which the MNP's are added before amplification and/or in which the MNP's are added after (or even during) the amplification. For identification, specifically modified MNP's may be used. For the magnetic marking, a specifically modified primer, Deoxynucleoside Triphosphates (dNTPs), DNA attaching proteins, hybridization probes or the like, to which the MNP's may be bound or at which correspondingly coated MNP's can attach and/or bind, may be used. Biotin-modification to which streptavidin coated MNP's bind may be used for example, the binding of DNA/RNA components and/or primers to the MNP's may be done using biotin-streptavidin interaction. The DNA/RNA/primer component may be modified with biotin, while particle surface may be modified with streptavidin. The term "specific" or "specifically modified" may refer to a specific bond between streptavidin and biotin. However, modifying the particles and, e.g., oligonucleotide sequences may depend on the assay design and the desired type of interaction. The MNP's can be purchased from companies with several modifications as desired or can be modified in the lab, for example, by using chemical crosslinking, electrostatic adsorption and/or polymer coating methods with different functional groups. The primers can be purchased with biotin modification from companies utilising the biotinylation method. In summary, it can be said that many different kinds of modifications are possible, wherein either one of the provided techniques being suitable.

According to the invention, the apparatus may comprise at least one, in particular thermal, controller configured to control, in particular modify, the one or more electrical signals to adjust and/or regulate a temperature for, in particular isothermal, amplification of the one or more substances.

The "controller", which can interchangeably also referred to as "controller unit", "thermal controller", "regulation unit" or "thermal regulation unit", may be a chip, a computer or computing device, a processor, a microprocessor, one or more integrated circuit(s), a system-on-chip (SoC) and/or a microcontroller, in particular a single-board microcontroller, for example an Arduino. Needless to say that the controller may further comprise additional, optional components like a memory, a communication module and/or one or more input-/output (I/O)-interfaces, e.g. to connect one or more I/O-devices or peripherals. The controller may be electrically, informationally, and/or communicatively connected to one or more components or even subcomponents of the apparatus, including the excitation assembly, the driver coil and/or the probing coil, and the detection assembly, including the detection coil and/or the reference coil. The controller may be included within the apparatus, e.g. within the housing or enclosure of the apparatus. However, an arrangement outside of the apparatus, e.g. outside the housing or enclosure, is also conceivable.

The controller may be arranged, adapted and/or configured to control, in particular modify, the one or more electrical signals, e.g. to regulate a temperature.

In particular, "controlling" and/or "modifying" the one or more electrical signals may include changing, altering, varying, transforming, adjusting, modulating, regulating, shifting and/or converting one or more properties, values, parameters, characteristics of the one or more electrical signals which are for example applied to excitation assembly. For example, the controller may be arranged and/or configured to modulate an amplitude, a frequency and/or a phase of the one or more electrical signals, in particular of the one or more electrical excitation signals or excitation signals.

Since the one or more electrical signals applied define the output of the excitation assembly, controlling and/or modifying the one or more electrical signals directly also results in controlling and/or modifying the output of the excitation assembly or its respective components and/or subcomponents, in particular the one or more magnetic fields provided thereby. However, applying electrical signals, in particular currents, at/to the excitation assembly further results in heat being generated, in particular heat generated by the driver coil providing the low frequency (LF) magnetic field or LF excitation component. The inventors have recognized that by controlling and/or modifying the electrical signals applied to the excitation assembly, in particular the driver coil or LF-coil, a temperature, e.g. within the apparatus, can be advantageously likewise controlled, adjusted, set, maintained, regulated, tuned and/or modified, varied, changed, altered etc., wherein the generated temperature may be directly utilized for, in particular isothermal, amplification of the one or more substances, e.g. within the apparatus.

The controller may be adapted and/or configured to control and/or modify the one or more electrical signals to provide different steps of heating, for example a pre-heating step, e.g. before the combined amplification and detection of the solution occurs, in particular even before the sample or the solution is placed or put inside the apparatus, in particular the sample chamber. An exemplary pre-heating step may include heating within the range of approximately 20°-80°, preferably approximately 30°-70° for a predetermined time, which may depend on the desired temperature. As an example, pre-heating may be within the range of approximately 3-12 minutes, preferably approximately 5-10 minutes.

Additionally or alternatively, another heating step, e.g. after pre-heating, may be carried out, in particular a heating for amplification, in particular isothermal amplification. In this heating step, the controller may be adapted and/or configured to control and/or modify the one or more electrical signals to provide a substantially constant temperature, in particular over at least a predetermined time interval, for the one or more substances. For example, a substantially constant temperature in the range of approximately 20°-80°, prereferral approximately 30-70° may be provided. Needless to say that in this heating step, the sample or the solution may be placed or put inside the apparatus, in particular in the sample chamber. The heating steps mentioned herein may include also a stepwise heating, e.g. a temperature increase/decrease in different steps over a certain period of time until a desired temperature value is reached. Also, gradually increasing/decreasing the temperature values is conceivable.

The at least one, in particular thermal, controller may be configured to control, in particular modify, the one or more electrical signals at least based on one or more temperature values, in particular surface temperature values, received from and/or determined, in particular detected, at the at least one excitation assembly, in particular the driver coil providing the low frequency (LF) magnetic field or LF excitation component. The temperature values may be detected using a sensor unit, e.g. a temperature sensor such as a DS18B20 digital temperature/feedback sensor. The sensor unit may be for example mounted either on the surface of the coil that is used to apply the LF component or as close to the sample position as, in particular technologically, possible. The digital DS18B20 has 3 legs, Vcc - supply voltage line, GND - ground line, and the signal line (note that for the complete description of the DS18B29, reference is made to the respective datasheet of the DS18B20 sensor). The sensor unit may also be referred to as "feedback sensor" or "feedback sensor unit", since the detected temperature values, in particular the surface temperature values of the driver coil, may be returned or fed back to the controller to be further analysed and/or used. The temperature values may also be used to provide reference values for the controlling and/or modifying of the one or more electrical signals. Due to the fact that the driver coil is located and/or arranged in close proximity to the sample chamber and/or the sample/solution located therein, a temperature, in particular a surface temperature, of the driver coil is indicative of, e.g. substantially corresponds to/is substantially proportional to, and/or correlated to a temperature at the sample/solution position.

The at least one, in particular thermal, controller may be configured to control, in particular modify, at least an amplitude, a phase and/or a frequency of the one or more electrical signals to provide one or more modulated electrical signals, preferably one or more pulse-width modulated electrical signals, for the at least one excitation assembly. As mentioned above, a modulated electrical signal may be a signal for which one or more of an amplitude, a frequency and/or a phase of the one or more electrical signals is varied, changed and/or altered. For example, amplitude modulation (AM), frequency modulation (FM), phase modulation (PM) and/or pulse width modulation may (PWM) may be applied. It is also conceivable to use a mixture/combination of one or more of the modulation techniques mentioned herein. Furthermore, Linear Quadratic Regulator (LQR) and/or Linear Quadratic Gaussian (LQG) may provide additional options to find the optimal control.

The apparatus and/or one or more components thereof may be substantially cylindrically shaped. For example, the apparatus may include an optional housing or enclosure, which may have a substantially cylindrical body which is hollow, e.g. to accommodate different components of the apparatus. It should be noted that not all components, such as the controller for example, must be located within the housing. The housing or enclosure may serve as a faraday cage which may serve to limit external influences. The housing or enclosure may be made from a aluminium, preferably "technical" aluminium, i.e. an alloy that is much cheaper and slightly different then pure aluminium. However, other materials such as titanium, silver and/or copper are generally also possible to use as a housing or enclosure, i.e. as faraday cages, but the same are much more expensive. The housing or enclosure may have an eloxated surface (i.e. artificial oxidization of the aluminium surface as a protective layer). The housing may be opened by using screws, e.g. unscrewing 4 small screws e.g. on the bottom of the cylinder.

The excitation assembly may surround, in particular enclose, the detection assembly, in particular coaxially. The excitation assembly and the detection assembly may be nested in one another, e.g. define a nested arrangement or structure. For example, the components of the excitation assembly, in particular the driver coil and/or the probing coil, may be substantially hollow-cylindrically shaped. Likewise, the components of the detection assembly, in particular the detection coil (and/or an optional reference coil) may be substantially hollow-cylindrically shaped.

In an exemplary embodiment the at least one excitation assembly may include a, in particular substantially hollow-cylindrically shaped, driver coil unit or driver coil and an, in particular substantially hollow-cylindrically shaped, probing coil unit or probing coil, wherein the driver coil surrounds, in particular encloses, the probing coil, in particular coaxially. In this respect, the driver coil and the probing coil may be nested in one another, e.g. define a nested arrangement or structure. The same may apply to the, in particular substantially hollow-cylindrically shaped, detection coil, which may be surrounded, in particular enclosed, by and/or aligned coaxially with the driver coil and/or the probing coil. Needless to say that the same may correspondingly apply to the optional, in particular substantially hollow-cylindrically shaped, reference coil. To this end, the driver coil, the probing coil and/or the detection coil (including the optional reference coil) may constitute a nested arrangement or configuration. This may allow to save space, in particular mounting space and/or to provide a miniaturized coil arrangement/configuration that allows a compact structure, which keeps the size of the apparatus as small as possible.

The apparatus may further comprise an, in particular insertable and/or removable, sample chamber for receiving the solution, wherein in particular the sample chamber may be substantially tube-shaped. The sample chamber may be arranged and/or dimensioned to, in particular in a mounted state of the sample chamber, provide the sample or solution located therein substantially at a central region of the apparatus. The sample chamber may be arranged and/or dimensioned to provide the solution, in particular at least sectionally, at a height of the detection coil assembly, in particular in a mounted state of the sample chamber. For example, in a mounted state, the sample may be located, in particular at least sectionally, at substantially the same height as the detection coil assembly, but preferably not at the height of the reference coil assembly. The height may be measured in the axial direction L or longitudinal axis L of the apparatus. The sample chamber may be embodied as a filter and/or filter column for preparation of the solution and/or for separation of the one or more substances, such as DNA- or RNA-sequences, and/or the one or more, in particular magnetic, nanoparticles (MNP's).

The housing or enclosure of the apparatus may include an opening, e.g. for receiving, inserting and/or accommodating the sample chamber. The opening may be located on a top side of the apparatus, e.g. when viewed in an axial direction L. After the sample chamber has been located, placed, arranged and/or put into the opening, the same may be closed with a plug, e.g. made from rubber. This may allow to provide a substantially homogeneous temperature distribution inside of the apparatus, e.g. inside the housing or the enclosure.

The apparatus may further comprise a graphic user interface (GUI). The GUI may be connected to the controller. The GUI may be adapted, configured and/or arranged to adjust and/or set one or more parameters, in particular operating parameters, of the apparatus such as temperature limits, time limits, frequency limits, amplitude limits, phase limits and/or signal duration. In particular, the GUI may adapted, configured and/or arranged to adjust and/or set i) temperature limits for pre-heating and/or heating and/or upper/lower temperature values, limits and/or thresholds; ii) heating type, e.g. gradual, constant and/or stepwise heating; iii) additional control parameters, e.g. to reduce control errors, for example for the temperature values; iv) (heating) times, e.g. heating duration; and/or time limits/intervals, e.g. for the heating steps; and/or v) an amplitude of excitation (excitation amplitude), e.g. for HF-excitation and/or LF-excitation. The GUI may be equipped with a display, e.g. a touchscreen, configured to receive input from a user.

The solution may be, in particular substantially liquid, and may include one or more substances, such as DNA- or RNA-sequences. In addition, the solution may comprise one or more of: proteins, Deoxynucleoside Triphosphates (dNTPs), amino acids, enzymes, salt and/or buffer solutions, deionized water labelled dNTPs, cofactors, primer binding enhancers, crowding agents, denaturants and/or dyes.

The apparatus described herein may be a, in particular single, portable and/or handheld apparatus or device configured to allow simultaneous and/or sequential

- amplification, in particular isothermal amplification, and
- detection, in particular concentration detection, of the solution.

For example, using the apparatus according to the invention, both amplification a detection can be carried our within the same device and/or directly on site. This offers the possibility to dispense with external thermoregulators/water baths which are typically used for nucleic acid amplification and to conduct isothermal amplifications and in particular also detection thereof portably, e.g. using a single handheld, or mobile device or apparatus. This also eliminates the need to send the sample to a laboratory to perform the same. The apparatus described herein may be also referred to a, in particular substantially cylindrically shaped, measuring head.

The invention also relates to a method for combined amplification and detection of a solution including one or more substances, such as DNA- or RNA-sequences, using a single apparatus, in particular an apparatus according to one or more of the aspects and/or embodiments disclosed herein, comprising the steps of:

providing one or more electrical signals to at least one excitation assembly for providing at least one excitation magnetic field for the solution;

detecting, using a detection assembly, a response magnetic field from at least one or more, in particular magnetic, nanoparticles (MNP) added to the solution;

regulating a temperature for amplification of the one or more substances by controlling, in particular modifying, the one or more electrical signals provided to the at least one excitation assembly.

The one or more, in particular magnetic, nanoparticles (MNP) may be added to the solution before, during and/or after the step of regulating the temperature for amplification of the one or more substances. The step of regulating the temperature for amplification of the one or more substances may be carried out simultaneously and/or sequentially to the step of detecting, using a detection assembly, of a response magnetic field from at least the one or more, in particular magnetic, nanoparticles (MNP) and/or to the step of adding the one or more, in particular magnetic, nanoparticles (MNP).

The method may further comprise receiving and/or determining one or more temperature values, in particular surface temperature values, from/at the at least one excitation assembly for regulating the temperature for amplification of the one or more substances.

The step of regulating the temperature for amplification of the one or more substances includes at least controlling, in particular, modifying, at least an amplitude, phase and/or a frequency of the one or more electrical signals to provide one or more modulated electrical signals, in particular one or more pulse-width modulated electrical signals. The method may further comprise a pre-heating step to a temperature in the range of about 20°C-80°C, particularly in the range of about 30°-70°C, in particular before combined amplification and detection of the solution and/or before arranging the sample or solution inside the apparatus. The method may further comprise controlling, in particular modifying, the one or more electrical signals to provide a substantially constant temperature, in particular over at least a predetermined time interval, for the one or more substances, in particular after a pre-heating.

The invention also relates to a computer-implemented method for determining and/or developing one or more models, in particular thermal models, indicative of a temperature behaviour of an apparatus, in particular according to one or more of the aspects and/or embodiments disclosed herein, for amplification, in particular isothermal amplification, and detection, in particular concentration detection, of a solution, including one or more substances, such as DNA- or RNA-sequences, comprising:

determining, on the basis of a first input value, in particular a power value of an excitation assembly, at least one heating approximation value on a first path of the model, and determining, on the basis of a second input value, in particular a temperature value, preferably an ambient temperature value, at least one cooling approximation value on a second path of the model.

The one or more models, in particular thermal models, may be used, developed and/or generated to (pre-)configure, adjust, test, tune, set the apparatus, in particular the controller, e.g. in a virtual, artificial and/or simulated environment rather than in a real, actual environment. For example, an implementation of the apparatus in a real or actual environment, e.g. in a real implementation/application, takes time and effort. Sometimes, it turns out that after implementation in a real environment, the apparatus is not suitable for the particular application or that there was a design/structural error in the first place. Thus, testing of the apparatus before actual implementation in the real environment by using one or more models, e.g. thermal models is preferred. This approach may not only allow to save time, but also to detect errors in the first place and/or to tailor the apparatus, in particular the controller, to a specific implementation/application as accurately as possible, i.e. to assure functionality once deployed in the real environment. For example, if the apparatus, in particular the controller, works well using the one or more developed models, it can be inferred, e.g. it is highly likely, that the apparatus, in particular, the controller, works also well in a real environment, i.e. under real conditions. The one or more models may be indicative of a temperature behaviour, temperature distribution and/or a temperature development/trajectory of the apparatus. In particular, the one or more models may simulate, mimic and/or represent a thermal behaviour of the apparatus, namely during combined amplification and detection as disclosed herein.

The one or more developed models may be validated. For example, input values may be selected/chosen and, on their basis, the model output may be determined, calculated and/or simulated. For the selected input values, a real system response may be detected and/or measured and compared with the model output. If the model output matches the detected and/or measured system output, e.g. within a predetermined range or threshold, the model may be considered to work for the input value and may thus be considered validated. This may be repeated for further, different and/or more input values.

The method or the one or more models may include at least a first path and a second path. A "path" of one or more models may be understood in a calculation path, trajectory and/or an evolution/propagation of the input value, parameter or variable, e.g. over time. According to the present invention, the first path and the second path may be different, in particular distinct, from one another. In particular the first path may be indicative of a heating process within the apparatus, e.g. when the driver coil is turned on and starts heating, e.g. starts generating heat due to a current being applied. For example, since the driver coil may correspond to the major element responsible for heating, the first path may be provided the power value (e.g. in watts, "W") of the driver coil as input, as the same is correlated with, indicative of and/or proportional to the heat produced thereat. As such, the first path may also be referred to the heating path of the model. Alternatively or additionally the second path may be indicative of a cooling process within the apparatus, e.g. when the driver coil is turned off. As such, the second path may be provided a temperature value, preferably an ambient temperature value, as input, particularly due to the fact that the temperature will start decreasing once the driver coil is turned off. As such, the second path may also be referred to the cooling path of the model. The reason for using a first and second path is that not only complexity is reduced, but also less computational power is needed. Having two different paths, e.g. first and second path, may enable parallel calculations/computations which required less time, e.g. can be calculated faster.

"input values", e.g. first, second, third input value etc., may be also referred to as input parameters and/or input variables and understood as values or parameters that are, e.g. initially, given to the one or more models, e.g. as an initial assumption. For example the first input value may be a power value (e.g. in watts, "W") of the excitation assembly, e.g. of the driver coil, preferably only or solely from the driver coil and not from the probing coil. The reason for using only the power value of the driver coil may be that a major part of the heat inside the apparatus is generated by the driver coil, e.g. due to resistive heating and/or since higher currents are applied. Considering only the power value of the driver coil reduces complexity of the one or more models, since considering (also) inputs related to the probing coil would require more i) computational effort; ii) memory storage space and/or iii) computational power/processing. In addition, the output of the model would not be positively affected and/or not be more accurate as the probing coil does not contribute much to the heat generated. In other words, contributions from the probing coil in the model may be neglected or negligible, which has advantageous effects with respect to complexity, processing overhead and storage space. The second input value maybe a temperature value, preferably an ambient temperature value, e.g. in the proximity of the sample. The second input value may correspond to a temperature value, e.g. an ambient temperature value, determined during application of the first input value, wherein the first input value corresponds to an average power value indicative of a temperature generated at and/or by the excitation assembly, in particular the driver coil.

In each respective path, i.e. the first path and/or the second path of the model, one or more approximations may be carried out to determine approximated values on the basis of the input values. For example, at least one heating approximation value may be determined in, at or on the first path of the model and at least one cooling approximation value may be determined on a second path of the model. The at least one heating approximation value and the at least one cooling approximation value may determined in parallel, in particular simultaneously, and/or separately, in particular individually, on the first path and the second path respectively. The at least one heating approximation value and/or the at least one cooling approximation value may be respectively determined on the first and second path on the basis of one or more Padé approximations, in particular of the following form:

$$R(x) = \frac{\sum_{j=0}^{m} a_j x^j}{1 + \sum_{k=1}^{n} b_k x^k} = \frac{a_0 + a_1 x + a_2 x^2 + \cdots + a_m x^m}{1 + b_1 x + b_2 x^2 + \cdots + b_n x^n} \qquad (1)$$

In case more than one approximation is carried out, e.g. on a respective path, it can be advantageous to use the determined approximation value, e.g. for heating/cooling, as input for the subsequent approximation. For example, in each path, e.g. the first path and the second path of the model, two or more approximations may be carried out. For example, a first heating approximation value is determined, e.g. on the first path of the model, on the basis of a first input value using a Padé approximations of the above equation (1). The first heating approximation value determined therefrom may be fed to a subsequent approximation branch, where another Padé approximation using the above formula (1) may be carried out, but this time on the basis of the first heating approximation value, wherein the output therefrom may be referred to as second heating approximation value. Likewise, it should be clear that a further approximation, e.g. a further Padé approximation, which takes the second heating approximation value as input and so on may be carried out. The same correspondingly applies to the at least one cooling approximation value and the second path. As mentioned above, this leads to less computational power, reduced complexity and enables parallel calculations/computations which required less time, e.g. as compared to one higher order approximation or the like. Using two Padé approximation blocks instead of one may enhance/improve computational effort, e.g. in terms of time to compute the resulting parameters. However, the model output is not altered thereby. For example, the computation is faster, e.g. the parameters in the transfer function blocks can be identified faster when the approximation was split into, for example, two parts with 5 parameters, rather then, for example a single block with 10 parameters. It may also enhance accuracy.

The computer-implemented method may further comprise combining, e.g. adding, the at least one determined heating approximation value with the at least one determined cooling approximation value to generate a combined approximation value. Combining the heating/cooling approximation value(s) may take into account that the process of heating and cooling inside the apparatus depend on each other, interact with each other and/or influence each other, as such, they can be added together. The combined approximation value may be indicative of a temperature behaviour in, e.g. inside, the apparatus, e.g. heating and cooling behaviour namely during combined amplification and detection as disclosed herein. The combined approximation value may be merged, e.g. fused, combined and/or brought together, preferably by addition, with an apparatus-related value. The apparatus-related value may be a value, property, variable, constant and/or parameter indicative of a, in particular physical and/or chemical, property of the apparatus itself, e.g. resulting from a size, dimension, structure and/or material or the like of the apparatus. In particular, the apparatus-related value may be, for example, a capability of the apparatus to store heat energy, e.g. inside a housing or enclosure thereof. Merging the combined approximation value(s) with the apparatus-related value may provide at least one modelled output value, in particular a modelled temperature output value for the apparatus.

The computer-implemented method may further include comparing the at least one modelled output temperature value for the apparatus to temperature values measured on the basis of the first and/or the second input value, e.g. using a sensor unit as disclosed herein. As mentioned above, for the selected input values, e.g. first and second input values, a real system response, e.g. actual/real temperature values, of the apparatus (e.g. inside the same) may be detected and/or measured, e.g. using the sensor unit therein, and compared with the modelled output value(s) to validate the one or more models. If the modelled output value matches the detected and/or measured system output, e.g. within a predetermined range or threshold, the model may be considered to work for the input value(s) and may thus be considered validated. This allows fine-tuning of the one or more models and may increase accuracy.

The computer-implemented method may further comprise feeding back (e.g. providing feedback) the at least one modelled temperature output value to the second path of the model as an additional input value. The additional input value may be referred to a third input value. Providing feedback allows fine-tuning of the one or more models and may increase accuracy. The physical intuition for feedback from the modelled temperature output value emerges as the cooling of the apparatus depends on a temperature difference between a heated object and its surroundings.

The computer-implemented method may further comprise repeating one or more of steps mentioned above, in particular repeating determining at least one heating approximation value and/or at least one cooling approximation value to provide a plurality of heating approximation values and/or cooling approximation values. To do this, different input values may be used for example. Then, the computer-implemented method may proceed with combining the determined plurality of heating approximation values with the determined cooling approximation values to generate a plurality of combined approximation values, merging the plurality of combined approximation values with apparatus-related values to provide a plurality of modelled temperature output values. Then, the computer-implemented method may proceed with summarizing, in particular integrating, over the plurality of modelled temperature output values, to provide e.g. a plurality of integrated values. In addition, the computer-implemented method may include repeating the step of providing feedback on the basis of the plurality of modelled temperature output values and/or the integrated values. The step of summarizing may be carried out before providing feedback.

The computer-implemented method may further include a step of scaling the first and/or the second input value(s) before determining the at least one heating approximation value on the first path of the model and/or before determining the at least one cooling approximation value on a second path of the model. "Scaling" in this context may be comparable to using a gain factor, e.g. in an electrical linear system.

Further aspects, advantages, and features are apparent from the dependent claims, the description, and the accompanying drawings.

BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:

FIG. 1A    shows a cross-sectional view of an apparatus according to the invention;

FIG. 1B    shows a cross-sectional view of an apparatus according to the invention;

FIG. 2    shows a diagram of a temperature behaviour of the apparatus according to the invention;

FIG. 3    shows a diagram comparing temperature values at a feedback sensor position and/or the driver coil and temperature values at a sample position;

FIG. 4    shows a schematic view of a computer-implemented method for determining and/or developing one or more models indicative of temperature behaviour;

FIG. 5A    shows a diagram of an exemplary first input value for the one or more models, e.g. a power value of the driver coil;

FIG. 5B    shows a diagram of an exemplary second input value for the one or more models, e.g. an ambient temperature; and

FIG. 5C    shows a diagram comparing the output of the one or more models, e.g. the modelled output temperature value with the measured output value at the apparatus.

Reference will now be made in detail to the various embodiments of the disclosure, one or more examples of which are illustrated in the figures. The drawings are schematic drawings which are not drawn to scale. Some elements in the drawings may have dimensions which are exaggerated for the purpose of highlighting aspects of the present disclosure and/or for the sake of clarity of presentation. To facilitate understanding, identical reference numerals have been used, where possible, to designate identical elements that are common to the figures. It is contemplated that elements and features of one embodiment may be beneficially incorporated in other embodiments without further recitation. Generally, only the differences with respect to individual embodiments are described.

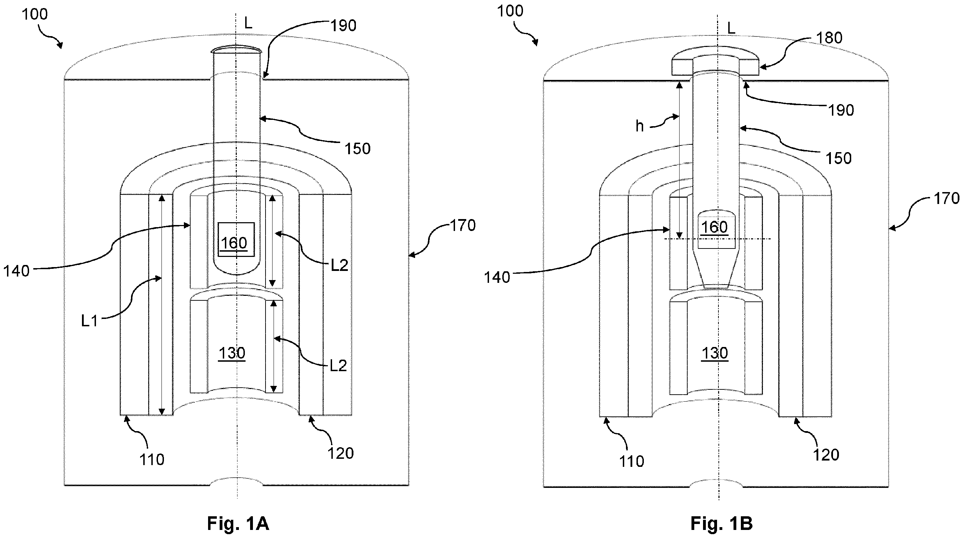

Figs. 1A and 1B show a cross-sectional view of an apparatus 100 according to the invention, e.g. an apparatus 100 for combined amplification and detection of a solution including one or more substances, such as nucleic acids, e.g. Deoxyribonucleic Acid (DNA)- and/or Ribonucleic Acid (RNA)-sequences. It should be noted that the apparatus 100 shown in Fig. 1A only differs from the apparatus 100 shown in Fig. 1B by the sample chamber 150 used, e.g. how the sample 160 is mounted. Apart from this, the apparatus 100 may be the same. Thus, Figs. 1A and 1B may be described together or in combination herein. The sample 160 may be a liquid, e.g. inside this liquid there may be the particles and/or e.g. nucleic acid materials and components needed for amplification. The sample chamber 150 may be, for example, a glass tubing filled with liquid or an immunofiltration column such as a polyethylene filter, where the nucleic acid capture probe or primer sequences may be bound to the filter and the nucleic acid modified particles can bind to their complementary sequence, that is immobilized on the filter.

As can be seen in Figs. 1A and 1B, the apparatus 100 comprises at least one excitation assembly 110, 120 which may be comprised of a first excitation coil 110, in particular a driver coil 110, or LF-coil 110 (may also referred to as outer coil), and a second excitation coil 120, in particular a probing coil 120 or HF-coil 120 (may also referred to as inner coil). The at least one excitation assembly 110, 120 may be configured to provide, on the basis of one or more electrical signals, at least one excitation magnetic field for the solution 160, which is e.g. arrangeable in the tube-like sample chamber 150.

In particular, the probing coil 120 or HF-coil 120 may refer to a coil responsible for providing a first or primary magnetic field B1, e.g. a high frequency (HF) magnetic field or HF excitation component, in particular on the basis of a first electrical signal, e.g. a first current. The driver coil 110 or LF-coil 110 may refer to a coil responsible for providing a second or secondary magnetic field B2, e.g. a low frequency (LF) magnetic field or LF excitation component, in particular on the basis of a second electrical signal, e.g. a second current, which may be different from the first current, e.g. different by frequency, amplitude and/or phase.

The electrical signals may comprise, as an example, two different electrical currents, e.g. two different alternating currents (AC) which have different frequencies f1 and f2 and/or, for example different amplitudes A1/A2, which may be applied to the driver coil 110 and the probing coil 120 respectively. For example, a first AC current, AC1, having a frequency f1 (or amplitude A1) may flow through/be applied to the probing coil 120 and a second AC current, AC2, having a frequency f2 (or amplitude A2) may flow through/be applied to the driver coil 110. The second current AC2 may have a higher amplitude than the first current AC1. The first frequency f1 may be different from the second frequency f2, e.g. following the relation f1 >f2 (note that in some cases f2>f1 may be conceivable). The second current AC2 being applied at and/or flowing through the driver coil 110 may be, in particular primarily, responsible for heat generation inside the apparatus. The probing coil 120 may be located (e.g. spatially) closer to the sample chamber 150 and/or the solution 160 as compared to the driver coil 110, which can be seen in Figs. 1A and 1B, because preferably, a smaller probing coil cross section results in lower coil inductance and, therefore, it is possible to apply higher currents for probing-field generation.

According to the invention, the apparatus 100 shown in Figs. 1A and 1B may comprise at least one detection assembly 130, 140 configured to receive and/or detect at least a response magnetic field from at least one or more, in particular magnetic, nanoparticles (MNP) added to the solution 160. The detection assembly 130, 140 may comprise one or more coils, preferably one or more detection coil(s) 140 and/or one or more reference coil(s) 130, arranged and/or configured to detect at least one magnetic field. For example, according to Faraday's law of induction, the detection assembly 130, 140 may experience or inhibit an induced voltage resulting from the excitation assembly 110, 120, in particular by the applied magnetic fields B1, B2 from the probing coil 120 and the driver coil 110 respectively. In addition thereto, the detection assembly 130, 140 may experience additional induced voltages, so called mixtures, (e.g. $HF \pm 2*NF$, $HF \pm 4*NF$, ..., etc.) resulting from additional magnetic fields or excitation components, e.g. from the magnetic nano particles (MNP) inside the solution 160.

According to the invention, the apparatus 100 shown in Figs. 1A and 1B may comprise at least one, in particular thermal, controller (not shown) configured to control, in particular modify, the one or more electrical signals to adjust and/or regulate a temperature for, in particular isothermal, amplification of the one or more substances, e.g. inside the solution 160. It should be noted that in Figs. 1A and 1B, additional components such as wires, cables and/or other electrical components are omitted for the sake of clarity/visibility. However, this should not be understood in that these components are not present, i.e. it is clear for the skilled person when one or more electrical signals are to be applied to the excitation assembly, a respective connection may be present to do so. The same applies to further additional components of the controller, like a memory, a communication module and/or one or more input-/output (I/O)-interfaces, e.g. to connect one or more I/O-devices or peripherals. The controller may be electrically, informationally, and/or communicatively connected to one or more components or even subcomponents of the apparatus, including the excitation assembly 110, 120, the driver coil 110 and/or the probing coil 120, and/or the detection assembly 130, 140, including the detection coil 140 and/or the reference coil 130. The controller may be included within the apparatus 100, e.g. within the housing 170 or enclosure 170 of the apparatus 100. However, an arrangement outside of the apparatus 100, e.g. outside the housing 170 or enclosure 170, is also conceivable.

The at least one, in particular thermal, controller may be configured to control, in particular modify, one or more electrical signals at least based on one or more temperature values, in particular surface temperature values, received from and/or determined, in particular detected, at the at least one excitation assembly 110, 120, in particular the driver coil 110, as the same is primarily responsible for the generated heat. These temperature values may be detected using a sensor unit (not shown in Figs. 1A and 1B), e.g. a temperature sensor such as a DS18B20 digital temperature/feedback sensor. The sensor unit may be for example mounted either on the surface of the coil that is used to apply the LF component or as close to the sample position as possible. The sensor unit may also be referred to as "feedback sensor" or "feedback sensor unit", since the detected temperature values, in particular the surface temperature values of the driver coil 110, are returned or fed back to the thermal controller to be further analysed and/or used. Due to the fact that the driver coil 110 is located and/or arranged in close proximity to the sample chamber 150 and/or the sample/solution 160 located therein, a temperature, in particular a surface temperature, of the driver coil 110 is indicative of, e.g. substantially corresponds to/is substantially proportional to, and/or correlated to a temperature at the sample/solution position, e.g. within the apparatus 100 or the housing 170.

The at least one, in particular thermal, controller may be configured to control, in particular modify, at least an amplitude, a phase and/or a frequency of the one or more electrical signals to provide one or more modulated electrical signals, preferably one or more pulse-width modulated electrical signals, for the at least one excitation assembly. As mentioned above, a modulated electrical signal may be a signal for which one or more of an amplitude, a frequency and/or a phase of the one or more electrical signals is varied, changed and/or altered. For example, amplitude modulation (AM), frequency modulation (FM), phase modulation (PM) and/or pulse width modulation may (PWM) may be applied. It is also conceivable to use a mixture/combination of one or more of the modulation techniques mentioned herein. Furthermore, Linear Quadratic Regulator (LQR) and/or Linear Quadratic Gaussian (LQG) may provide additional options to find the optimal control.

As can be seen in Figs. 1A and 1B, the apparatus 100 and/or one or more of its components (subcomponents) may be substantially cylindrically shaped. For example, the housing 170 or enclosure 170 of the apparatus 100 may have a substantially cylindrical body 170 which is hollow, e.g. to accommodate different components of the apparatus. The apparatus 100 and/or the housing may be rotationally symmetrical, e.g. around the axial or longitudinal axis L.

In particular, the excitation assembly 110, 120 may surround, in particular enclose, the detection assembly 130, 140, in particular coaxially, e.g. with respect to axial direction L of the apparatus 100. The excitation assembly 110, 120 and the detection assembly 130, 140 may be nested in one another, e.g. define a nested arrangement or structure. For example, the driver coil 110 may be located on the outside of the nested arrangement. This may be related to the fact that the driver coil 110 is not primarily responsible for heat generation. The driver coil 110 may surround, in particular enclose, the probing coil 120, in particular coaxially, e.g. around axis L. The driver coil 110 and/or the probing coil 120 may be substantially hollow-cylindrically shaped and/or having a substantially equal length, e.g. in the axial direction L. The driver coil 110 and the probing coil 120 may engage with one another, in particular contact and/or about one another. The driver coil 110 may be thicker than the probing coil 120, since the driver (e.g. LF) coil may have more, e.g. approximately four times as many, windings as the probing (e.g. HF) coil. For example, the driver coil 110 may have a thickness, in particular a wall thickness, of approximately 3,6 mm and/or the probing coil 120 may have a thickness of approximately 0,83 mm. Copper wires may be used having a wire diameter of approximately 0,18 mm. It should be noted that these thickness values are merely examples and the thicknesses may vary, e.g. based on the winding technology, the winding quality (packaging density) and/or based on the copper wire diameter used for the coils. The detection coil 140 and/or the optional reference coil 130 may also be substantially hollow-cylindrically shaped. Compared to the length L1 of the driver coil 110 and/or the probing coil 120, the length L2, e.g. measured also in the axial direction L, of the detection coil 140 and/or the reference coil 130 may be smaller, in particular substantially only half of the length L1. An exemplary length of the coils 110, 120 may be approximately 24 mm; these are also merely exemplary. The driver coil 110 and the probing coil 120 may enclose, in particular surround, the detection coil 140 (including the optional reference coil 130), e.g. coaxially, so as to constitute a nested arrangement, structure or configuration. This may allow to save space, in particular mounting space and/or to provide a miniaturized coil arrangement/configuration that allows a compact structure, which keeps the size of the apparatus 100 as small as possible.

The apparatus 100 shown in Figs. 1A and 1B may further comprise an, in particular insertable and/or removable, sample chamber 150 for receiving the solution 160, wherein in particular the sample chamber 150 may be substantially tube-shaped. The sample chamber 150 may be arranged and/or dimensioned to, in particular in a mounted state of the sample chamber 150, provide the sample 160 or solution 160 located therein substantially at a central region of the apparatus 100, in particular at least sectionally, at a height h of the detection coil 140. For example, as can be seen in Fig. 1B, in a mounted state, the sample 160 may be located, in particular at least sectionally, at substantially the same height h as the detection coil 140, but preferably not at the height of the reference coil 130. The sample 160 may be substantially fully surrounded by the detection coil 140. The height h may be measured in the axial direction L or longitudinal axis L of the apparatus, e.g. starting form a top side of the housing 170. To do so, the sample chamber may have certain length, which may be defined using a spacer 180. The sample chamber 150 may be embodied as a filter and/or filter column for immobilization of the solution 160 and/or for separation of the one or more substances, such as DNA- or RNA-sequences, and/or the one or more, in particular magnetic, nanoparticles (MNPs).

As can be further seen in Figs. 1A and 1B, the housing 170 or enclosure 170 of the apparatus 100 may include an opening 190, e.g. for receiving, inserting and/or accommodating the sample chamber 150. The opening 190 may be located on a top side of the apparatus 100, e.g. inside a wall or lid of the housing 170 or enclosure 170, when viewed in an axial direction L. After the sample chamber 150 has been located, placed, arranged and/or put into the opening 190, the same may be closed with a plug (not shown), e.g. made from rubber. This may allow to provide a substantially homogeneous temperature distribution inside of the apparatus 100, e.g. inside the housing 170 or the enclosure 170.

The apparatus 100 may further comprise a graphic user interface (GUI) (not shown). The GUI may be connected to the controller. The GUI may be adapted, configured and/or arranged to adjust and/or set one or more parameters, in particular operating parameters, of the apparatus such as temperature limits, time limits, frequency limits, amplitude limits, phase limits and/or signal duration. In particular, the GUI may be adapted, configured and/or arranged to adjust and/or set i) temperature limits for pre-heating and/or heating and/or upper/lower temperature values, limits and/or thresholds; ii) heating type, e.g. gradual, constant and/or stepwise heating; iii) additional control parameters, e.g. to reduce control errors, for example for the temperature values; iv) (heating) times, e.g. heating duration; and/or time limits/intervals, e.g. for the heating steps; and/or v) an amplitude of excitation (excitation amplitude), e.g. for HF-excitation and/or LF-excitation. The GUI may be equipped with a display (also not shown), e.g. a touchscreen, configured to receive input from a user.

The apparatus 100 according to the invention shown in Figs. 1A and 1B is arranged and/or configured for combined amplification and detection, e.g. the apparatus 100 is arranged and/or configured to perform both i) amplification, in particular isothermal amplification, e.g. of a sample, solution and/or target material, such as DNA- and/or RNA sequences, and ii) detection, in particular concentration detection, preferably of the amplified sample, solution and/or target material. In other words, amplification i) and detection ii) can be carried out using a single apparatus 100 as shown in Figs. 1A and 1B, e.g. simultaneously (e.g. in parallel and/or at the same time) and/or sequentially (e.g. one after another and/or successively). In particular, combined amplification and detection may be carried out by means of and/or within the single, e.g. the same, device or apparatus 100, preferably portably and/or mobile. This offers the possibility to dispose, or omit, or make superfluous external thermoregulators/water baths which are typically used for nucleic acid amplification and to conduct isothermal amplifications and in particular also detection thereof portably, e.g. using a single handheld, or mobile device or apparatus 100 as shown in Figs. 1A and 1B.

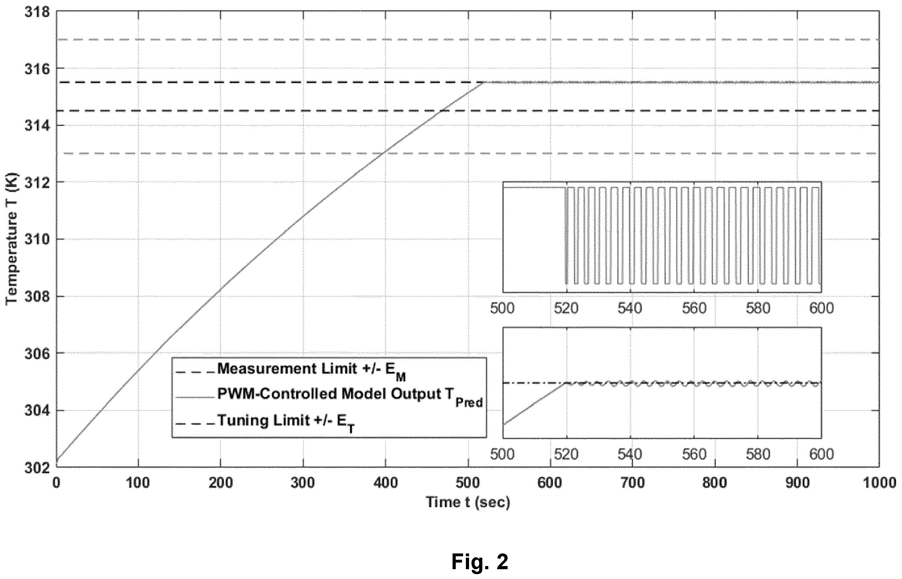

Figs. 2 shows a temperature behaviour of the apparatus 100, e.g. inside the apparatus 100, e.g. inside the housing 170. The diagram shown in Fig. 2 has time t in seconds on the x-axis and temperature T in K (Kelvin) on the y-axis. As can be seen, during a first time period, e.g. between 0 and 520 seconds, a, in particular substantially constant and/or gradual, heating occurs, e.g. by applying a current to the excitation assembly, e.g. the driver coil 110. During a second time period, e.g. after 520 seconds, the controller controls the electrical signals applied to the driver coil 110, e.g. by switching the same on and off, e.g. alternating therebetween. By doing so, a substantially constant temperature may be provided inside the apparatus 100. Figure 2 particularly shows the simulation output of a pulse width modulation (PWM) control of the temperature in the measurement head by means of an on-off cycling of the low frequency power. "Simulated output" may mean, that a MATLAB model was used, a simple PWM controller logic with 2 error ranges was implemented in the feedback loop from the model output to the controllable LF power input of the model. The first inset (small picture in the Graph window) shows this LF power on-off cycling. The second inset shows that the control around the setpoint temperature is tight and does not suffer from large fluctuations. The temperature that is controlled here was measured by the feedback sensor, such as a DS18B20 digital temperature/feedback sensor.

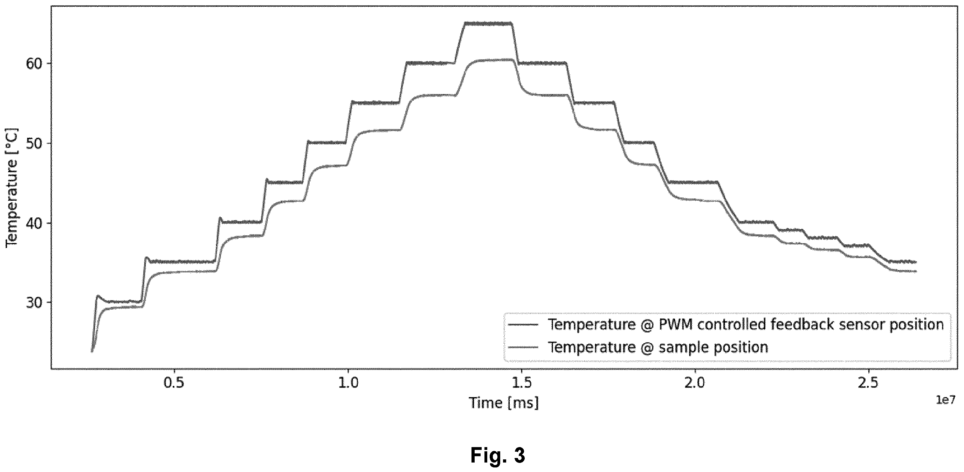

Fig. 3 shows a diagram comparing temperature values at a feedback sensor position and/or the driver coil 110 and temperature values at a sample position 160. The diagram shown in Fig. 3 has time t in milliseconds [ms] on the x-axis and temperature T in °C (Celsius) on the y-axis. As can be seen, the temperature values at the feedback sensor position and temperature values at the sample position 160 are closely correlated. In Fig. 3, a step-wise heating is shown, e.g. including different subsequent steps of reaching a desired temperature. As discussed above, the feedback sensor position may not exactly be at the sample position but in its vicinity or on the LF coil surface. Therefore, Figure 3 shows the relation of the temperature of the feedback sensor to the temperature at the sample position for different temperatures. The feedback temperature may be the controlled temperature, which is measured by the feedback sensor. However, the temperature that should be kept constant especially is the sample position temperature. As the sample position is occupied by the sample, the feedback sensor cannot be at the exact same position. The relation between the feedback sensor position temperature and sample position temperature is depicted in Figure 3. More specifically, the upper curve is the feedback controller position temperature graph and the lower curve is the sample position temperature curve. What is not shown in the graph, but important to understand is, that using the steady state values of these graphs, a linear relation between the feedback sensor position and sample position can be shown. This relation can be used to select the temperature setpoint (the temperature that needs to be set at the feedback sensor position) in order to reach the desired temperature at the sample position.

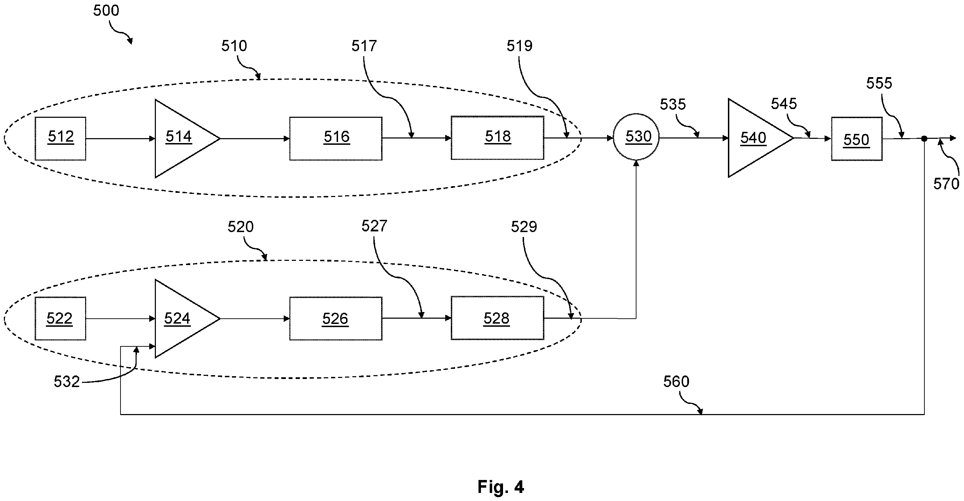

Fig. 4 is a schematic view of a computer-implemented method 500 for determining and/or developing one or more models, in particular thermal models, indicative of a temperature behaviour of an apparatus, in particular according to one or more of the aspects and/or embodiments disclosed herein, e.g. the single apparatus 100 shown in Figs. 1A and 1B, for amplification, in particular isothermal amplification, and detection, in particular concentration detection, of a solution, including one or more substances, such as DNA- or RNA-sequences. The computer-implemented method may comprise:

determining, on the basis of a first input value 512, in particular a power value of an excitation assembly, at least one heating approximation value 516 on a first path 510 of the model, and
determining, on the basis of a second input value 522, in particular a temperature value, preferably an ambient temperature value, at least one cooling approximation value 526 on a second path 520 of the model.

The one or more models, in particular thermal models, developed and/or generated e.g. using the method shown in Fig. 4, may be used, to (pre-)configure, adjust, tune, test, set the apparatus 100, in particular the controller, e.g. in a virtual, artificial and/or simulated environment rather than in a real, actual environment. For example, an implementation of the apparatus in a real or actual environment, e.g. in a real implementation/application, takes time and effort. Sometimes, it turns out that after implementation in a real environment, the apparatus is not suitable for the particular application or that there was a design/structural error in the first place. Thus, testing of the apparatus before actual implementation in the real environment by using one or more models, e.g. thermal models is preferred. This approach may not only allow to save time, but also to detect errors in the first place and/or to tailor the apparatus, in particular the controller, to a specific implementation/application as accurately as possible, i.e. to assure functionality once deployed in the real environment. For example, if the apparatus, in particular the controller, works well using the one or more developed models, it can be inferred, e.g. it is highly likely, that the apparatus, in particular, the controller, works also well in a real environment, i.e. under real conditions. The one or more models may be indicative of a temperature behaviour, temperature distribution and/or a temperature development/trajectory of the apparatus. In particular, the one or more models may simulate, mimic and/or represent a thermal behaviour of the apparatus, namely during combined amplification and detection as disclosed herein.

The method or the one or more models may include at least a first path 510 and a second path 520, e.g. a calculation paths 510, 520. According to the present invention, the first path 510 and the second path 520 may be different, in particular distinct, from one another. In particular the first path 510 may be indicative of a heating process within the apparatus 100, e.g. when the driver coil 110 is turned on and starts heating, e.g. starts generating heat due to a current being applied. For example, since the driver coil 110 may correspond to the major element responsible for heating, the first path 510 may be provided the power value (e.g. in watts, "W") of the driver coil 110 as input 512, as the same is correlated with, indicative of and/or proportional to the heat produced. As such, the first path 510 may also be referred to the heating path of the model. Alternatively or additionally the second path 520 may be indicative of a of a cooling process within the apparatus 100, e.g. when the driver coil 110 is turned off. As such, the second path 520 may be provided a temperature value, preferably an ambient temperature value, e.g. within the housing 170 of the apparatus 100, as input 522, particularly due to the fact that the temperature will start decreasing once the driver coil 110 is turned off. As such, the second path 520 may also be referred to the cooling path of the model. The reason for using a first 510 and second path 520 is that heating and cooling processes require different model descriptions. Having two different paths, e.g. first and second path, may enable parallel calculations/computations which required less time.

As mentioned, the first input value 512 may be a power value (e.g. in watts, "W") of the driver coil 110, preferably only or solely from the driver coil 110 and not from the probing coil 120. The reason for only using the power value of the driver coil 110 may be that a major part of the heat inside the apparatus 100 is generated by the driver coil 110, e.g. due to resistive heating and/or since higher currents are applied. Considering the power value of the driver coil only reduces complexity of the one or more models, since considering (also) inputs related to the probing coil would require more i) computational effort; ii) memory storage space and/or iii) computational power/processing. In addition, the output of the model would not be positively affected as the probing coil does not contribute much to the heat generated. In other words, contributions from the probing coil 120 in the model may be neglected or is negligible, which has advantageous effects with respect to complexity, processing overhead and storage space. The second input value 522 maybe a temperature value, preferably an ambient temperature value, e.g. in the proximity of the sample 160. The second input value 522 may correspond to a temperature value, e.g. an ambient temperature value, determined during application of the first input value 512.

In each respective path, i.e. the first path 510 and/or the second path 520 of the model, one or more approximations 516/518, 526, 528 may be carried out to determine approximated values on the basis of the input values 512, 522. For example, at least one heating approximation value (e.g. output of 516/518) may be determined in or on the first path 510 of the model and at least one cooling approximation value (e.g. output of 526/528) may be determined on a second path 520 of the model. The at least one heating approximation value and the at least one cooling approximation value may be determined in parallel, in particular simultaneously, and/or separately, in particular individually, on the first path 510 and the second path 520 respectively. The at least one heating approximation value and/or the at least one cooling approximation value may be respectively determined on the first 510 and second path 520 on the basis of one or more Padé approximations, in particular of the following form:

$$R(x) = \frac{\sum_{j=0}^{m} a_j x^j}{1 + \sum_{k=1}^{n} b_k x^k} = \frac{a_0 + a_1 x + a_2 x^2 + \cdots + a_m x^m}{1 + b_1 x + b_2 x^2 + \cdots + b_n x^n} \qquad (1)$$

In case more than one approximation is carried out, it can be advantageous to use the determined approximation value, e.g. for heating/cooling, as input for the subsequent approximation. For example, in each path, e.g. the first path 510 and the second path 520 of the model, two or more approximations 516/518 and/or 526/528 may be carried out. For example, a first heating approximation value 517 is determined on the first path 510 of the model, on the basis of a first input value 512 using a Padé approximations of the above equation (1). The first heating approximation value 517 determined therefrom may be fed to a subsequent approximation branch or box 518, where another Padé approximation using the above formula (1) from may be carried out, but this time on the basis of the first heating approximation value 517, wherein the output therefrom may be referred to as second heating approximation value 519. Likewise, it should be clear that a further approximation, e.g. a further Padé approximation, which takes the second heating approximation value 519 as input and so on may be carried out. The same correspondingly applies to the at least one cooling approximation value (indicated in Fig. 4 as 527 or 529) and the second path 520. As mentioned above, this leads to less computational power, reduced complexity and enables parallel calculations/computations which required less time, e.g. as compared to one higher order approximation or the like. Using two padé approximation blocks instead of one may enhance/improve computational effort, e.g. in terms of time to compute the resulting parameters. However, the model output is not altered thereby. For example, the computation is faster, e.g. the parameters in the transfer function blocks can be identified faster when the approximation was split into, for example, two parts with 5 parameters, rather then, for example a single block with 10 parameters. It may also enhance accuracy.

The computer-implemented method 500 may further comprise combining 530, e.g. adding, the at least one determined heating approximation value 519 with the at least one determined cooling approximation value 529 to generate a combined approximation value 535. Combining the heating/cooling approximation value(s) 519/529 may take into account that the process of heating and cooling inside the apparatus 100 depends on each other, interact with each other and/or influence each other, as such, they can be added together. The combined approximation value 535 may be indicative of a temperature behaviour in, e.g. inside, the apparatus 100, e.g. heating and cooling behaviour namely during combined amplification and detection as disclosed herein. The combined approximation value 535 may be merged, e.g. fused, combined and/or brought together, preferably by addition 540, with an apparatus-related value. The apparatus-related value may be a value, property, variable and/or parameter indicative of a, in particular physical and/or chemical, property of the apparatus 100 itself, e.g. resulting from a size, dimension, structure and/or material or the like of the apparatus 100. In particular, the apparatus-related value may be, for example, a capability of the apparatus 100 to store heat energy, e.g. inside a housing 170 or enclosure 170 thereof. Merging 540 the combined approximation value(s) 535 with the apparatus-related value may provide at least one modelled output value 545, in particular a modelled temperature output value 545 for the apparatus 100. Block 550 may be optional.

The computer-implemented method 500 may further include comparing the at least one modelled output temperature value 545 for the apparatus 100 to temperature values measured on the basis of the first and/or the second input value 512, 522. As mentioned above, for the selected input values, e.g. first and second input values 512, 522, a real system response, e.g. actual/real temperature values, of the apparatus 100 (e.g. inside the same) may be detected and/or measured, e.g. using the sensor unit therein, and compared with the modelled output value(s) to validate the one or more models. If the modelled output value 545 matches the detected and/or measured system output, e.g. within a predetermined range or threshold, the model may be considered to work for the input value(s) 512, 522 and may thus be considered validated. This allows fine-tuning of the one or more models and may increase accuracy.

The computer-implemented method 500 may further comprise feeding back 560 (e.g. providing feedback 560) the at least one modelled temperature output value 545 to the second path 520 of the model as an additional input value 532 or third input value 532. Providing feedback 560 allows fine-tuning of the one or more models and may increase accuracy. The physical intuition for feedback 560 from the modelled temperature output value 545 emerges as the cooling of the apparatus 100 depends on a temperature difference between a heated object and its surroundings.

The first and simplest idea for a controller according to the invention may be, to turn the first input 512 (e.g. average power) on and off, in order to control the heat supply to the apparatus. For example, at any time instance the model output is compared to a desired control (target) value (target 1). Every time the result of model output - target 1 is > 0, the driver coil will be turned off to cool down the apparatus. If target 1 is <0, the driver coil will be turned on to heat the MH.

The computer-implemented method 500 may further comprise repeating one or more of steps mentioned above, in particular repeating determining at least one heating approximation value 517/519 and/or at least one cooling approximation value 527/529 to provide a plurality of heating approximation values and/or cooling approximation values. Then, the computer-implemented method 500 may proceed with combining 530 the determined plurality of heating approximation values with the determined cooling approximation values to generate a plurality of combined approximation values 535, merging 540 the plurality of combined approximation values 535 with apparatus-related values to provide a plurality of modelled temperature output values 535. Then, the computer-implemented method 500 may proceed with summarizing 550, in particular integrating 550, over the plurality of modelled temperature output values 545, to provide e.g. a plurality of integrated values 555. In addition, the computer-implemented method 500 may include repeating the step of providing feedback 560 on the basis of the plurality of modelled temperature output values 545 and/or the integrated values 555. The step of summarizing 550 may be carried out before providing feedback 560, e.g. before box 550.

The computer-implemented method 500 may further include a step of scaling 514 the first and/or the second input value(s) 512, 522 before determining the at least one heating approximation value 517/519 on the first path 510 of the model and/or before determining the at least one cooling approximation value 527/529 on a second path 520 of the model. "Scaling" in this context may be comparable to using a gain factor, e.g. in an electrical linear system.

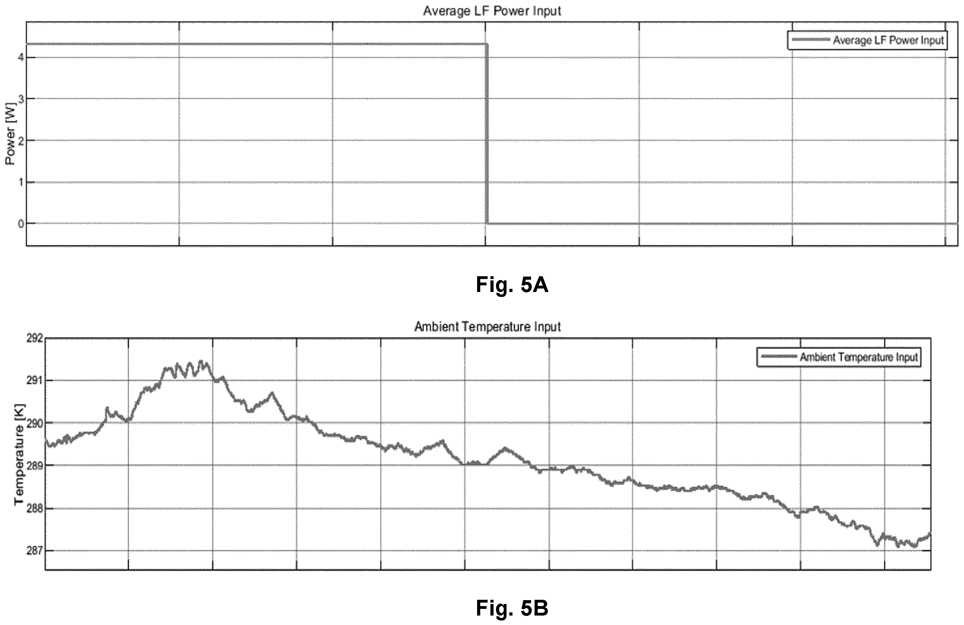

Fig. 5A shows a diagram of an exemplary first input value 512 e.g. for the computer-implemented method 500 shown in Fig.4. The diagram shown in Fig. 5A has time t in seconds on the x-axis and power in W (Watts) on the y-axis. The power may be a power measured at the driver coil 110, which may be indicative of a heating process, in particular a temperature or heating temperature, within the apparatus 100 (or housing 170), e.g. when the driver coil is turned on and starts heating, e.g. starts generating heat due to a current being applied. For example, since the driver coil 110 may correspond to the major element responsible for heating, the power value (e.g. in watts, "W") of the driver coil 110 may be used as input, as the same is correlated with, indicative of and/or proportional to the heat produced. As can be seen in Fig. 5A, during a first time, a current is applied to the driver coil 110 resulting in a power value being present. During a second time, e.g. later, the current is not applied to the driver coil 110, resulting in no power value being present. This may correspond to switching the driver coil 110 on and off. In other words, Figure 5A shows the electrical LF-power (which is one of the model inputs) over time. First the power is turned on and then turned off. Accordingly, the apparatus, e.g. the measurement head (which is what the lumped parameter model describes) should heat for turned on LF-power and cool for turned off LF-power.

Fig. 5B shows a diagram of an exemplary second input value 512, e.g. an ambient temperature value of the apparatus 100, e.g. for the computer-implemented method 500 shown in Fig. 4. Fig. 5B shows how the ambient temperature behaves in case the driver coil 110 is switched off, e.g. no heating occurs inside the apparatus 100 (or housing 170). The diagram shown in Fig. 5B has time t in seconds on the x-axis and temperature in K (Kelvin) on the y-axis. As can be seen in Fig. 5A, when no heating occurs, the ambient temperature is gradually decreasing. As such, Figure 5B shows the ambient temperature profile. It is the second model input, as it has influence on the measurement head temperature. The current ambient temperature affects, how fast the apparatus, e.g. the measurement head heats and cools. However, this input is a disturbance and obviously not controllable, as the ambient temperature underlies a plethora of effects. Still, it is important to consider in order to model the measurement head temperature.

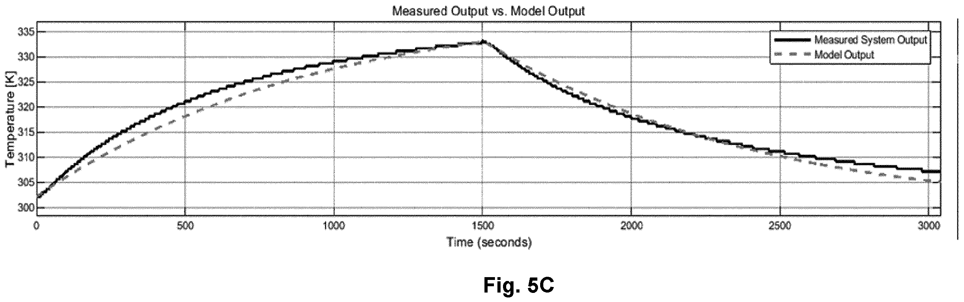

Fig. 5C shows a diagram comparing the output of the one or more models, e.g. the modelled output temperature value (dashed, grey line) with the measured output value (black solid line) at the apparatus 100, e.g. a validation of the model. The diagram shown in Fig. 5C has time t in seconds on the x-axis and temperature in K (Kelvin) on the y-axis. Figure 5C shows the model output or temperature "prediction" from the model, based on the given inputs in 5A and 5B. This model output is overlaid to actual measured temperature data of the model for identifying it as a correct model.

It is to be understood that application of the teachings of the present invention to a specific problem or environment, and the inclusion of variations of the present invention or additional features thereto (such as further aspects and embodiments), will be within the capabilities of one having ordinary skill in the art in light of the teachings contained herein.

Unless context dictates otherwise, the descriptions and definitions of the features set out above are not limited to any particular aspect or embodiment of the invention and apply equally to all aspects and embodiments which are described.

All references, patents, and publications cited herein are hereby incorporated by reference in their entirety.

Examples:

Example 1 provides an apparatus for combined amplification and detection of a solution including one or more substances, such as DNA- or RNA-sequences, comprising:

at least one excitation assembly configured to provide, on the basis of one or more electrical signals, at least one excitation magnetic field for the solution;
at least one detection assembly configured to receive and/or detect at least a response magnetic field from at least one or more, in particular magnetic, nanoparticles (MNP) added to the solution; and
at least one, in particular thermal, controller configured to control, in particular modify, the one or more electrical signals to adjust and/or regulate a temperature for, in particular isothermal, amplification of the one or more substances.

Example 2 includes the apparatus according to example 1, wherein the at least one, in particular thermal, controller is configured to control, in particular modify, the one or more electrical signals at least based on one or more temperature values, in particular surface temperature values, received from and/or determined, in particular detected, at the at least one excitation assembly.

Example 3 includes the apparatus according to the preceding examples, wherein the at least one, in particular thermal, regulation unit is configured to control, in particular modify, at least an amplitude, a phase and/or a frequency of the one or more electrical signals to provide one or more modulated electrical signals, preferably one or more pulse-width modulated electrical signals, for the at least one excitation assembly.

Example 4 includes the apparatus according to the preceding examples, wherein the at least one excitation assembly includes a, in particular substantially hollow-cylindrically shaped, driver coil and an, in particular substantially hollow-cylindrically shaped, probing coil, wherein in particular the driver coil surrounds, in particular encloses, the probing coil, in particular coaxially.

Example 5 includes the apparatus according to the preceding examples, wherein the one or more electrical signals include a first electrical current and a second electrical current, wherein the first electrical current differs from the second electrical current, wherein in particular the first electrical current has a different, in particular lower, frequency than the second electrical current.

Example 6 includes the apparatus according to the preceding examples, wherein the at least one detection assembly includes

a, in particular substantially hollow-cylindrically shaped, detection coil for detecting the response magnetic field, wherein the response magnetic field is, in particular an induced magnetic field, which is indicative of a concentration of the one or more, in particular magnetic, nanoparticles (MNP), and
optionally, a, in particular substantially hollow-cylindrically shaped, reference coil.

Example 7 includes the apparatus according to example 6, wherein the, in particular substantially cylindrically shaped, detection coil and/or optionally the, in particular substantially cylindrically shaped, reference coil, are arranged to be surrounded, in particular enclosed, by the probing coil and/or the driver coil, in particular coaxially.

Example 8 includes the apparatus according to the preceding examples, further comprising an, in particular insertable and/or removable, sample chamber for receiving the solution, wherein in particular the sample chamber is substantially tube-shaped, wherein the sample chamber is arranged and/or dimensioned to, in particular in a mounted state of the sample chamber, provide the solution substantially at a central region of the apparatus, in particular, at least sectionally, at a height of the detection coil assembly.

Example 9 includes the apparatus according to example 8, wherein the sample chamber is arranged and/or dimensioned to provide the solution, in particular at least sectionally, at a height of the detection coil assembly, in particular in a mounted state of the sample chamber.

Example 10 includes the apparatus according to the preceding examples 8-9, wherein the sample chamber includes a filter and/or filter column for preparation of the solution and/or for separation of the one or more substances, such as DNA- or RNA-sequences, and/or the one or more, in particular magnetic, nanoparticles (MNP).

Example 11 includes the apparatus according to the preceding examples, further comprising a graphic user interface (GUI) to adjust and/or set one or more operating parameters of the apparatus, such as temperature limits, time limits, frequency limits, amplitude limits, phase limits and/or signal duration.

Example 12 includes the apparatus according to the preceding examples, wherein the solution further comprises one or more of: proteins, Deoxynucleoside Triphosphates (dNTPs), amino acids, enzymes, salt and/or buffer solutions, and/or deionized water.

Example 13 includes the apparatus according to the preceding examples, wherein the at least one, in particular thermal, controller is a microcontroller, in particular a single-board microcontroller, preferably an Arduino.

Example 14 includes the apparatus according to the preceding examples, wherein the apparatus is a, in particular single, portable and/or handheld apparatus configured to allow simultaneous and/or sequential

- amplification, in particular isothermal amplification, and
- detection, in particular concentration detection, of the solution,

wherein in particular the apparatus is a, in particular substantially cylindrically shaped, measuring head.

Example 15 includes a method for combined amplification and detection of a solution including one or more substances, such as DNA- or RNA-sequences, using a single apparatus, in particular an apparatus according to one of the preceding examples, comprising the steps of:

providing one or more electrical signals to at least one excitation assembly for providing at least one excitation magnetic field for the solution;

detecting, using a detection assembly, a response magnetic field from at least one or more, in particular magnetic, nanoparticles (MNP) added to the solution;

regulating a temperature for amplification of the one or more substances by controlling, in particular modifying, the one or more electrical signals provided to the at least one excitation assembly.

Example 16 includes the method according to example 15, wherein the one or more, in particular magnetic, nanoparticles (MNP) are added to the solution before or after the step of regulating the temperature for amplification of the one or more substances.

Example 17 includes the method according to one or more of the preceding examples, wherein the step of regulating the temperature for amplification of the one or more substances is carried out simultaneously and/or sequentially to the step of detecting, using a detection assembly, of a response magnetic field from at least the one or more, in particular magnetic, nanoparticles (MNP) and/or to the step of adding the one or more, in particular magnetic, nanoparticles (MNP).

Example 18. includes the method according to one or more of the preceding examples, further comprising: receiving and/or determining one or more temperature values from/at the at least one excitation assembly for regulating the temperature for amplification of the one or more substances.

Example 19 includes the method according to one or more of the preceding examples, wherein the step of regulating the temperature for amplification of the one or more substances includes at least controlling, in particular, modifying, at least an amplitude, phase and/or a frequency of the one or more electrical signals to provide one or more modulated electrical signals, in particular one or more pulse-width modulated electrical signals.

Example 20 includes the method according to one or more of the preceding examples, further comprising a pre-heating step to a temperature in the range of about 20°C-80°C, particularly in the range of about 30°-70°C, in particular before combined amplification and detection of the solution.

Example 21 includes the method according to one or more of the preceding examples, further comprising controlling, in particular modifying, the one or more electrical signals to provide a substantially constant temperature, in particular over at least a predetermined time interval, for the one or more substances, in particular after a pre-heating.

Example 22 includes a computer-implemented method for determining and/or developing one or more models, in particular one or more thermal models, indicative of a temperature behaviour of an apparatus, in particular according to one or more of the examples 1-14, for amplification, in particular isothermal amplification, and detection, in particular concentration detection, of a solution, including one or more substances, such as DNA- or RNA-sequences, comprising:

determining, on the basis of a first input value, in particular a power value of an excitation assembly, at least one heating approximation value on a first path of the model, and

determining, on the basis of a second input value, in particular a temperature value, preferably an ambient temperature value, at least one cooling approximation value on a second path of the model.

Example 23 includes the computer-implemented method according to example 22, wherein the first path and the second path are different, in particular distinct, from one another, in particular the first path being indicative of a heating process within the apparatus and/or the second path being indicative of a of a cooling process within the apparatus.

Example 24 includes the computer-implemented method according to one of the examples 22-23, wherein the second input value corresponds to a temperature value determined during application of the first input value, wherein the first input value corresponds to an average power value indicative of a temperature generated at and/or by the excitation assembly.

Example 25 includes the computer-implemented method according to one of the examples 22-24, wherein the at least one heating approximation value and the at least one cooling approximation value are determined in parallel, in particular simultaneously, and/or separately, in particular individually, on the first path and the second path respectively.

Example 26 includes the computer-implemented method according to one of the examples 22-25, wherein the at least one heating approximation value and/or the at least one cooling approximation value are respectively determined on the first and second path on the basis of one or more Padé approximations, in particular of the following form:

$$R(x) = \frac{\sum_{j=0}^{m} a_j x^j}{1 + \sum_{k=1}^{n} b_k x^k} = \frac{a_0 + a_1 x + a_2 x^2 + \cdots + a_m x^m}{1 + b_1 x + b_2 x^2 + \cdots + b_n x^n}$$

Example 27 includes the computer-implemented method according to one of the examples 22-25, further comprising:

combining the at least one determined heating approximation value with the at least one determined cooling approximation value to generate a combined approximation value.

Example 28 includes the computer-implemented method according to example 27, further comprising:

merging the combined approximation value with an apparatus-related value indicative of a capability of the apparatus to store heat energy to provide at least one modelled temperature output value for the apparatus.

Example 29 includes the computer-implemented method according to example 28, further comprising:

comparing the at least one modelled output temperature value for the apparatus to temperature values measured on the basis of the first and/or the second input value.

Example 30 includes the computer-implemented method according to one of the examples 28-29, further comprising:

feeding back the at least one modelled temperature output value to the second path of the model as an additional input value.

Example 31 includes the computer-implemented method according to one of the examples 22-30, further comprising:

repeating the step of determining at least one heating approximation value and/or at least one cooling approximation value to provide a plurality of heating approximation values and/or cooling approximation values, and

combining the determined plurality of heating approximation values with the determined cooling approximation values to generate a plurality of combined approximation values,

merging the plurality of combined approximation values with apparatus-related values to provide a plurality of modelled temperature output values, and

summarizing, in particular integrating, over the plurality of modelled temperature output values.

Example 32 includes the computer-implemented method according to one of the examples 22-31, further comprising:

scaling the first and/or the second input value before determining the at least one heating approximation value on the first path of the model and/or before determining the at least one cooling approximation value on a second path of the model.

Example 33 includes an apparatus, in particular data processing apparatus, comprising means, in particular at least one processor, for carrying out the method according to one or more of the examples 22-32.

Example 34 includes a computer program product comprising instructions, which, when the program is executed by a computer, cause the computer to carry out the method according to one or more of the examples 22-32.

Example 35 includes a computer-readable storage medium comprising instructions, which, when executed by a computer, cause the computer to carry out the method according to one or more of the examples 22-32.

While the foregoing is directed to embodiments of the disclosure, other and further embodiments of the disclosure may be devised without departing from the basic scope thereof, and the scope thereof is determined by the claims that follow.

**Claims**

1. Apparatus for combined amplification and detection of a solution including one or more substances, such as DNA- or RNA-sequences, comprising:

at least one excitation assembly configured to provide, on the basis of one or more electrical signals, at least one excitation magnetic field for the solution;

at least one detection assembly configured to receive and/or detect at least a response magnetic field from at least one or more, in particular magnetic, nanoparticles (MNP) added to the solution; and
at least one, in particular thermal, controller configured to control, in particular modify, the one or more electrical signals to adjust and/or regulate a temperature for, in particular isothermal, amplification of the one or more substances.

2. Apparatus according to claim 1, wherein the at least one, in particular thermal, controller is configured to control, in particular modify, the one or more electrical signals at least based on one or more temperature values, in particular surface temperature values, received from and/or determined, in particular detected, at the at least one excitation assembly.

3. Apparatus according to one of the preceding claims, wherein the at least one, in particular thermal, regulation unit is configured to control, in particular modify, at least an amplitude, a phase and/or a frequency of the one or more electrical signals to provide one or more modulated electrical signals, preferably one or more pulse-width modulated electrical signals, for the at least one excitation assembly.

4. Apparatus according to one of the preceding claims, wherein the at least one excitation assembly includes a, in particular substantially hollow-cylindrically shaped, driver coil and an, in particular substantially hollow-cylindrically shaped, probing coil, wherein in particular the driver coil surrounds, in particular encloses, the probing coil, in particular coaxially.

5. Apparatus according to one of the preceding claims, wherein the one or more electrical signals include a first electrical current and a second electrical current, wherein the first electrical current differs from the second electrical current, wherein in particular the first electrical current has a different, in particular higher, frequency than the second electrical current.

6. Apparatus according to one of the preceding claims, wherein the at least one detection assembly includes

   a, in particular substantially hollow-cylindrically shaped, detection coil for detecting the response magnetic field, wherein the response magnetic field is, in particular an induced magnetic field, which is indicative of a concentration of the one or more, in particular magnetic, nanoparticles (MNP), and
   optionally, a, in particular substantially hollow-cylindrically shaped, reference coil.

7. Apparatus according to claim 6, wherein the, in particular substantially cylindrically shaped, detection coil and/or optionally the, in particular substantially cylindrically shaped, reference coil, are arranged to be surrounded, in particular enclosed, by the probing coil and/or the driver coil, in particular coaxially.

8. Apparatus according to one of the preceding claims, further comprising an, in particular insertable and/or removable, sample chamber for receiving the solution, wherein in particular the sample chamber is substantially tube-shaped, wherein the sample chamber is arranged and/or dimensioned to, in particular in a mounted state of the sample chamber, provide the solution substantially at a central region of the apparatus, in particular, at least sectionally, at a height of the detection coil assembly,
wherein in particular the sample chamber is arranged and/or dimensioned to provide the solution, in particular at least sectionally, at a height of the detection coil assembly, in particular in a mounted state of the sample chamber.

9. Apparatus according claim 8, wherein the sample chamber includes a filter and/or filter column for preparation of the solution and/or for separation of the one or more substances, such as DNA- or RNA-sequences, and/or the one or more, in particular magnetic, nanoparticles (MNP).

10. Apparatus according to one of the preceding claims, further comprising a graphic user interface (GUI) to adjust and/or set one or more operating parameters of the apparatus, such as temperature limits, time limits, frequency limits, amplitude limits, phase limits and/or signal duration,

   wherein in particular the solution further comprises one or more of: proteins, Deoxynucleoside Triphosphates (dNTPs), amino acids, enzymes, salt and/or buffer solutions, and/or deionized water, labeled dNTPs, cofactors, primer binding enhancers, crowding agents, denaturants, and/or dyes,
   wherein in particular the at least one, in particular thermal, controller is a microcontroller, in particular a single-board microcontroller, preferably an Arduino.

11. Apparatus according to one of the preceding claims, wherein the apparatus is a, in particular single, portable and/or handheld apparatus configured to allow simultaneous and/or sequential

   - amplification, in particular isothermal amplification, and
   - detection, in particular concentration detection, of the solution,

   wherein in particular the apparatus is a, in particular substantially cylindrically shaped, measuring head.

12. Method for combined amplification and detection of a solution including one or more substances, such as DNA- or RNA-sequences, using a single apparatus, in particular an apparatus according to one of the preceding claims, comprising the steps of:

   providing one or more electrical signals to at least one excitation assembly for providing at least one excitation magnetic field for the solution;
   detecting, using a detection assembly, a response magnetic field from at least one or more, in particular magnetic, nanoparticles (MNP) added to the solution;
   regulating a temperature for amplification of the one or more substances by controlling, in particular modifying, the one or more electrical signals provided to the at least one excitation assembly.

13. Method according to claim 12, wherein the one or more, in particular magnetic, nanoparticles (MNP) are added to the solution before or after the step of regulating the temperature for amplification of the one or more substances, wherein in particular the step of regulating the temperature for amplification of the one or more substances is carried out simultaneously and/or sequentially to the step of detecting, using a detection assembly, of a response magnetic field from at least the one or more, in particular magnetic, nanoparticles (MNP) and/or to the step of adding the one or more, in particular magnetic, nanoparticles (MNP).

14. Method according to one or more of the preceding claims, further comprising:

   receiving and/or determining one or more temperature values from/at the at least one excitation assembly for regulating the temperature for amplification of the one or more substances,
   wherein in particular the step of regulating the temperature for amplification of the one or more substances includes at least controlling, in particular, modifying, at least an amplitude, phase and/or a frequency of the one or more electrical signals to provide one or more modulated electrical signals, in particular one or more pulse-width modulated electrical signals.

15. Method according to one or more of the preceding claims, further comprising a pre-heating step to a temperature in the range of about 20°C-80°C, particularly in the range of about 30°-70°C, in particular before combined amplification and detection of the solution,
   wherein in particular the method further comprises controlling, in particular modifying, the one or more electrical signals to provide a substantially constant temperature, in particular over at least a predetermined time interval, for the one or more substances, in particular after a pre-heating.

Fig. 1B

Fig. 1A

Fig. 2

Legend:
- Measurement Limit +/- $E_M$
- PWM-Controlled Model Output $T_{Pred}$
- Tuning Limit +/- $E_T$

Temperature T (K) vs. Time t (sec)

Fig. 3

Fig. 4

Average LF Power Input

**Fig. 5A**

Ambient Temperature Input

**Fig. 5B**

**Fig. 5C**

Europäisches Patentamt
European Patent Office
Office européen des brevets

# EUROPEAN SEARCH REPORT

**Application Number**

EP 24 15 3492

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2011/128807 A1 (KONINKL PHILIPS ELECTRONICS NV [NL]; VEEN JEROEN [NL] ET AL.) 20 October 2011 (2011-10-20) | 1-3,5,9, 12-15 | INV. B01L7/00 G01N27/74 |
| Y | * the whole document * | 4,6-8, 10,11 | G01R33/12 |
| Y | US 2023/204542 A1 (WU KAI [US] ET AL) 29 June 2023 (2023-06-29) * paragraph [0097]; figure 12A * | 4,6-8, 10,11 | |
| A | JP 2006 061031 A (HITACHI MAXELL) 9 March 2006 (2006-03-09) * the whole document * | 1,12 | |

**TECHNICAL FIELDS SEARCHED (IPC)**

B01L
G01R
G01N
A61B

The present search report has been drawn up for all claims

| Place of search | Date of completion of the search | Examiner |
|---|---|---|
| The Hague | 31 July 2024 | Vlassis, Maria |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 15 3492

This annex lists the patent family members relating to the patent documents cited in the above-mentioned European search report.
The members are as contained in the European Patent Office EDP file on
The European Patent Office is in no way liable for these particulars which are merely given for the purpose of information.

31-07-2024

| Patent document cited in search report | Publication date | Patent family member(s) | Publication date |
|---|---|---|---|
| WO 2011128807 A1 | 20-10-2011 | NONE | |
| US 2023204542 A1 | 29-06-2023 | EP 4136439 A1 | 22-02-2023 |
| | | US 2023204542 A1 | 29-06-2023 |
| | | WO 2021212144 A1 | 21-10-2021 |
| JP 2006061031 A | 09-03-2006 | NONE | |

EPO FORM P0459

For more details about this annex : see Official Journal of the European Patent Office, No. 12/82